(19) Europäisches Patentamt European Patent Office Office européen des brevets

(11) **EP 2 926 150 B1**

(12) **EUROPEAN PATENT SPECIFICATION**

(45) Date of publication and mention
of the grant of the patent:
**04.01.2017 Bulletin 2017/01**

(51) Int Cl.:
**G01R 1/04** *(2006.01)*        **G01R 1/073** *(2006.01)*
**G01R 1/067** *(2006.01)*

(21) Application number: **13814035.5**

(22) Date of filing: **27.11.2013**

(86) International application number:
**PCT/EP2013/003587**

(87) International publication number:
**WO 2014/082742 (05.06.2014 Gazette 2014/23)**

(54) **CANTILEVER CONTACT PROBE FOR A TESTING HEAD**

FREITRAGENDE KONTAKTSONDE FÜR PRÜFKOPF

SONDE DE CONTACT À CANTILEVER POUR TÊTE D'ESSAI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.11.2012 IT MI20122023**

(43) Date of publication of application:
**07.10.2015 Bulletin 2015/41**

(73) Proprietor: **Technoprobe S.p.A
23870 Cernusco Lombardone (Lecco) (IT)**

(72) Inventors:
 • **VETTORI, Riccardo
 I-23870 Cernusco Lombardone (Lecco) (IT)**
 • **BERTARELLI, Emanuele
 I-23870 Cernusco Lombardone (Lecco) (IT)**
 • **DIEGIDIO, Marco
 I-23870 Cernusco Lombardone (Lecco) (IT)**

(74) Representative: **Ferrari, Barbara
Botti & Ferrari S.r.l.
Via Cappellini, 11
20124 Milano (IT)**

(56) References cited:
**US-A- 3 599 093        US-A1- 2003 151 419
US-A1- 2008 204 062**

EP 2 926 150 B1

**Description**

Technical field

The present invention refers to a cantilever contact probe for a testing head.

More in particular, the invention refers to a cantilever contact probe having at least a probe body and a hook-shaped end portion, which is slanted starting at a bending point with respect to the probe body and ending with a contact tip for ensuring a mechanical and electrical contact with a contact pad of a device under test.

The invention also refers to a testing head comprising a plurality of cantilever contact probes.

Prior art

As is known, a testing head is essentially a device for electrically connecting a plurality of contact pads of a micro-structure (such as an integrated circuit or generally an electronic device) to corresponding channels of a testing apparatus or machine which has to test the same.

The test, which is performed on integrated circuits, allows the detection and insulation of defective circuits, yet in the production phase. Normally, testing heads are therefore used for electrical testing of wafer based electrical circuits, prior to cutting and assembling the same inside a chip containment package.

It is therefore known that the efficiency and reliability of a measuring test relies, among other things, on the provision of a good electrical connection between the microstructure, or in general a device under test, and testing apparatus, and therefore, an optimal electrical contact between probe and pad.

It is also known that the electrical connection testing apparatus/device and hence probe/pad, though originally good, may with time undergo a substantial degradation and possibly vanish, because of dirt deposits and oxide formation on the contact pads of the device under test.

For ensuring the reliability and efficiency of a measuring test, it is therefore necessary to provide a "cleaning" of said contact pads.

Among the testing heads used in this particular technical field, for testing integrated circuits, the so called cantilever probe testing heads, which are provided with cantilevered probes, similar to fishing rods suspended over the device under test, are widely used.

In particular, a cantilever testing head of the known type usually supports a plurality of flexible, generally rod-like probes, having predetermined electrical and mechanical properties. The probes, which protrude from the cantilever testing head, have a substantially hook-shaped form, because of an end section essentially having an elbow bend with an inner obtuse angle.

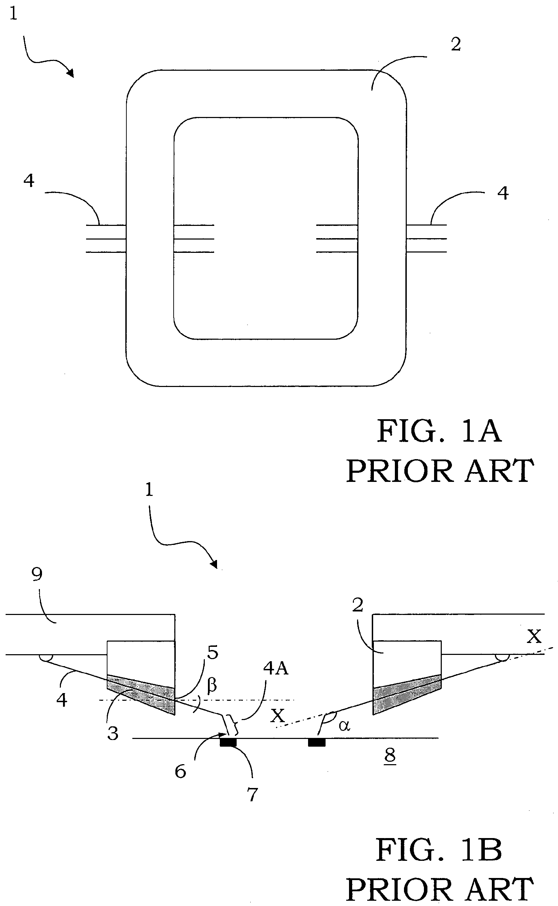

In particular, as schematically shown in Figures 1A and 1B, a testing head 1 having cantilevered probes usually comprises a supporting ring 2, made of aluminum, ceramics or other suitable material, which is usually coupled to a support 3 made of resin, able to include a plurality of movable contact elements or contact probes 4, which are usually composed of special alloy wires, with good electrical and mechanical properties, which protrude from the resin support 3 at a plurality of points 5 forming a suitable angle with a plane of the device under test 8, which is usually called body angle, schematically shown by $\beta$ in the figure of the drawing. Such probes are commonly called cantilever probes.

In particular, the contact probes 4 have a hook-shaped end portion 4A bent to a suitable angle $\alpha$ with respect to the axis XX of the probes and ending with a contact tip 6, which is able to contact a plurality of contact pads 7 of a device under test 8.

The portion of the contact probes 4 outside the supporting ring 2 is usually welded to a printed circuit or board 9, as shown in Figure 1B, in order to provide an electric contact between the testing head 1 with the cantilever probes and the test apparatus.

A good connection between the contact probes 4 of the testing head 1 and the contact pads 7 of the device under test 8 is ensured by a pressure of the testing head 1 against the same device, wherein the contact probes 4 are subject to a vertical bending directed in an opposite direction with respect to the movement of the device towards the head.

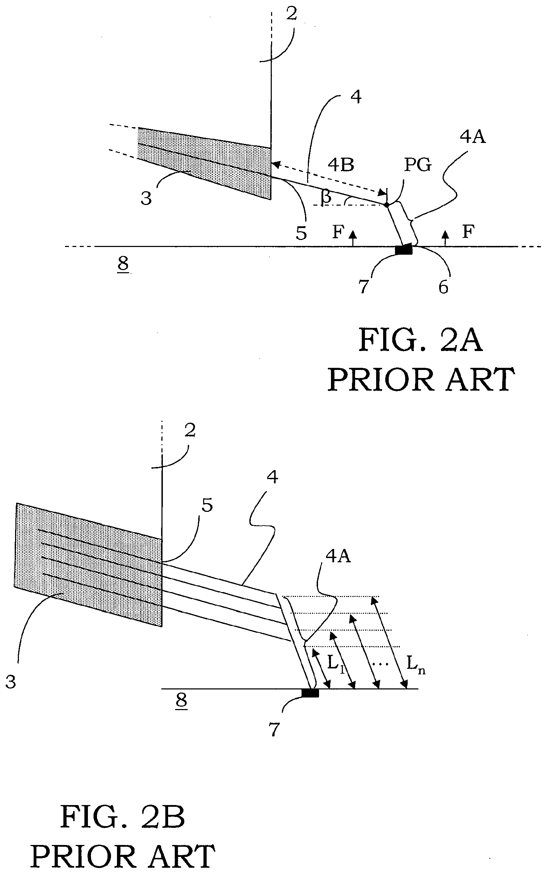

As schematically shown in Figure 2A, with reference to a single contact probe 4, when device under test 8 moves vertically against the hook-shaped end portion 4A (as shown by the arrows FF in this figure), the contact probe 4 bends and its bending point, labeled as PG, which is the intersection between the hook-shaped end portion 4A and a probe section protruding with respect to the resin support 3, labeled as 4B, travels along a circular arc.

The protruding section 4B of the probe forms a working arm for the contact probe 4 during its vertical bending movement, and is usually called "free length".

The hook-like shape of the contact probes 4 is such that during contact with the contact pads 7 of the device under test 8 and their upward travel or "overtravel" beyond the predetermined contact location, the contact tips 6 of the probes 4 slide over the contact pads 7 in the direction defined by the system geometry.

It is to be noted that the force caused by each contact probe 4 on the contact pads 7 is a function of various factors, wherein the main factors are the type of material making the probe, its shape, the angle $\alpha$ of its hook-shaped end portion 4A, the length of its protruding section or free length 4B and the overtravel of the pads 7 of the device under test 8. Such factors also define the sliding length of the contact tips 6 over the contact pads 7, which is commonly known a "scrub".

In fact, such a sliding movement corresponds to a "scrubbing" or "brushing" of the surface of the contact pad 7, causing the removal of a layer of dirt or oxide which may be present on the same.

The sliding movement or scrubbing of the contact tips 6 over the pads 7 should allow a durable and optimal electrical contact between the probes 4 and the pads 7 of the device under test 8.

In particular it is of utmost importance to ensure a sufficient scrub of the contact tips on the contact pads 7, allowing a surface "cleaning" of same pads, improving the contact realized by the testing head 1.

This technique, though advantageous for the application on integrated circuits of the type being commonly used until recently, notoriously has a major technical drawback in case of cleaning recently designed integrated circuits. In fact, integrated circuits (and similar micro-structures) designed and manufactured in recent times have increasing densities of the contact pads, and decreasing pad sizes.

In particular, the need to obtain a sufficient scrub of the contact pads 7 in order to ensure an electrical contact with the device under test 8, in all operating conditions of the testing head 1, contrasts with the current need by the market to design increasingly denser devices, with contact pads 7 whose size is more and more decreasing. The movement of the contact tips 6 of the probes 4 over the contact pads 7 which allows a sufficient scrub is such that, in devices having pads with reduced sizes, there is a risk of the contact tip 6 to cross the boundaries of the same pad 7, not ensuring an electrical connection with the device under test 8, and possibly damaging the probe 4 or the device 8 itself.

The movement of the tips over the pads causes an incision of the latter and gives rise to incision marks which are usually called "scrub marks".

A low value of scrub mark is indicative of a low invasiveness of a test, thus reducing damages to the contact pads 7 caused by the tips of the contact probes 4, and this in turn allows for a good quality of the following connection (bonding) with such pads.

It is therefore necessary to provide contact probes 4 which generate the smallest possible scrub marks.

Known testing heads also have intrinsic limits regarding the distance between two adjacent or contiguous probes, i.e. the center-to-center distance between two adjacent contact pads 7 of the device under test 8, indicated as "pitch" in the field. In particular, the minimum value of "pitch" of the pads which may be tested varies according to the geometric conditions and the size of the probes. In order to avoid that contiguous probes contact each other, the testing head 1 has to comply with the following relationship:

$$PL > fc + S$$

wherein:

PL is the distance between the contact tips of adjacent contact probes;

fc is the diameter of the contact probes 4; and

S is the safety distance between adjacent contact probes 4.

Condition S-0, i.e. a safety distance equal to zero, corresponds to the probes colliding.

It is to be noted that the diameter fc of the contact probes 4 is usually taken into account, since such probes are normally formed by metal wires with a circular cross section. More generally, the probe's diameter is understood as the maximum dimension of its section perpendicular to a longitudinal extension axis of the same probe, which, according to the previous definitions, is considered as extending along the side by side placing direction of the probes, i.e. where they can contact each other.

According to the current technologies, in order to increase the number of probes, with a same pitch value, it is known to reduce the size of the contact probes 4, in particular their diameter fc, causing a weakening of the same. Such a solution is therefore applicable in a limited number of cases only.

US patent application No. 2008/0204062 discloses a cantilever contact probe wherein at least a portion of the hook-shaped tip is flattened by stamping or pressing devices, resulting in a reduced size along a first side by side placing direction of the probes and at the same time in an increased size along a second direction, orthogonal to the first direction, of the flattened portion with respect to the non-flattened portion.

It is also known that, with high density contact pads 7, the contact probes 4 are positioned over multiple levels or layers, therefore varying the lengths L1,....Ln of the hook-shaped end portions 4A, as schematically shown in Figure 2B.

The number N of levels required for positioning a plurality of contact probes 4 having diameter fc over contact pads 7 having distance or pitch equal P, ensuring a safety distance S between each other, is calculated according to the following empirical formula:

$$N = (fc + S)/P \text{ (rounded to the next higher integer)}.$$

In case of testing heads having cantilever contact probes 4 positioned on multiple levels, the problem caused by collision of probes has evidently a three-dimensional character. In particular, the sites with the greatest risk of contact are the bending points PG of a probe at a level corresponding to a slightly tapered area of the hook-shaped end portion 4A of adjacent contact probes 4.

It is therefore advantageous, if possible, to position the contact probes 4 on a minimum number of levels.

Essentially, the choice of the positioning arrangement of the contact probes 4 over multiple levels depends on various factors, among which the most important are the following:

- available space for the contact probes 4 as a whole;

- diameter fc of each contact probe 4;

- shape of the hook-shaped end portions 4A; and

- pitch of the device under test 8.

Considering a fixed pitch value for the device under test 8, it is possible to increase the number of probes housed on each level by reducing their diameter.

However it is to be noted that the contact probes 4 having a small diameter have a lower mechanical and electrical performance, due to the increase of the contact resistance between hooks and pads of the device under test 8, because of the lower pressure which is applied by the tips of the contact probes 4 on the respective contact pads 7.

It can be easily shown that also the length of the scrub marks is heavily influenced by the hook's length. An increase of the number N of levels, which causes an increase of the hook's length, causes also an increase of the associated scrub marks.

In particular, in a testing head having contact probes 4 on N levels, the probe of level 11, having a hook length of L1, produces a shorter scrub mark with respect to the probe at level 12, having a hook length L2, which in turn is shorter than the one generated by the probe on level 13, having a hook length L3.

The probe belonging to the higher level, ln, having a longest hook, Ln, will therefore create a longest scrub mark and will consequently inflict the maximum damage to the contact pads 7.

The need of placing the probes on multiple levels essentially contrasts the need of limiting or even reducing the length of the scrub marks, i.e. the damage caused to the contact pads and the risk of crossing their borders, even more so because the size of the contact pads is steadily decreasing.

Moreover, by increasing the levels, the collision risk among the probes on higher levels is also increased, because their minimum mutual distance is also decreased, due to the conical shape of the probes.

As will become apparent from the above description, there are contrasting needs which require very precarious compromises to be made, and which severely compromise a good functionality of the testing head according to the prior art.

The technical problem to be solved by the present invention is to provide a cantilever contact probe with an arrangement such as to reduce the probability of a contact even in a device under test having a reduced pitch, to increase the safety distance between probes and to reduce the scrub of the tips over the contact pads, at the same time ensuring a proper mechanical and electrical contact between the probes and the contact pads.

Summary of the invention

The solution idea of the present invention is to modify the arrangement of the contact probes in at least a portion of their probe body, reducing the thickness of said body along a side by side placing direction of the probes.

According to the above solution idea, the technical problem is solved by a cantilever contact probe comprising at least a probe body and a hook-shaped end portion, being joined to the probe body and ending with a slanted section, being configured as a hook, the end portion being bent at a bending point having a suitable inclination of the hooked slanted section with respect to a longitudinal extension axis of the probe and ending with a contact tip being able to ensure a mechanical and electrical contact with a contact pad of a device under test, characterized in that it comprises at least a reduced portion having a first area with at least a first size being smaller than a corresponding first size of a second area of the probe in a section which does not comprise the reduced portion, along a side by side placing direction of the probes within a testing head, the reduced portion being substantially reduced along its sides, thus forming an area having a reduced cross size being placed edgeways.

According to an aspect of the invention, the ratio between the first size of the first area at the reduced portion and the size of the second area may be chosen in the range 0.30 - 0.95.

According to another aspect of the invention, the reduced portion may be symmetrical with respect to the longitudinal extension axis of the probe.

Moreover, according to an aspect of the invention, the first area of the probe at the reduced portion has a second size along the orthogonal direction with respect to the side by side placing direction of the probes which is greater than the first size.

According to another aspect of the invention, the contact tip may comprise a corrugated contact portion.

Moreover, the reduced portion may be provided in a section of the probe body adjoining the end portion.

The reduced portion may also be provided in a section of the end portion at the bending point.

According to an aspect of the invention, the probe may comprise a reduced portion provided in a section of the probe body adjoining the end portion and a further reduced portion provided in a section of the end portion at the bending point.

According to another aspect of the invention, the value of the first size of the first area at the reduced portion may be chosen according to a value of a distance between the centers of the contact pads of the device under test.

Moreover, according to another aspect of the invention, the value of the second size of the first section at the reduced portion may be chosen according to a current that the probe should sustain.

According to a further aspect of the invention, the values of first and second sizes of the first area at the reduced portion may be chosen to control the contact force of the probe onto a contact pad of the device under test or to balance probes having slanted sections of different length or to contact pads being internal to the device.

The value of the first size of the first area at the reduced portion may vary between 25 $\mu$m and 200 $\mu$m and the value of the first size of the second area may vary between 50 $\mu$m and 300 $\mu$m. Alternatively, the value of the first size of the first area at the reduced portion may vary between 20 $\mu$m and 180 $\mu$m and the value of the first size of the second area may vary between 30 $\mu$m and 200 $\mu$m. Moreover, the value of the second size of the first area at the reduced portion may vary between 50 $\mu$m and 400 $\mu$m.

According to another aspect of the invention, the first area at the reduced portion may have a shape chosen between a substantially quadrilateral figure which comprises two opposed rectilinear sides and two opposed curvilinear sides, a rectangle, a square, and an ellipse.

The technical problem is also solved by a testing head comprising at least a ring support, which is jointly coupled to a further resin support being able to include a plurality of cantilever contact probes according to the preceding aspects.

According to an aspect of the invention, the testing head may comprise at least a first level of contact probes having at least a reduced portion provided in a section of the end portion at the bending point and a second level of contact probes devoid of the reduced portion.

The characteristics and advantages of the contact probe and f the testing head according to the invention will be provided in the following description of their embodiments, provided as illustrative and non limiting examples, with reference to annexed drawings.

Brief description of drawings

In the drawings:

-    Figure 1A shows a view from above of a testing head with cantilever probes according to the prior art,

-    Figure 1B shows a front sectional view of the testing head with cantilever probes of Figure 1A,

-    Figure 2A shows a sectional view of a detail of the testing head with cantilever probes of Figure 1A,

-    Figure 2B shows a sectional view of a detail of another embodiment of a testing head with cantilever probes according to the prior art,

-    Figure 3A shows a perspective view of a cantilever contact probe according to the prior art,

- Figure 3B shows a sectional transversal view of a cantilever contact probe of Figure 3A,

- Figure 4A shows a perspective view of a cantilever contact probe according to an embodiment of the invention,

- Figures 4B and 4C show sectional views of the cantilever contact probe of Figure 4A,

- Figure 5A shows a perspective view of a testing head including cantilever contact probes according to Figure 4A,

- Figure 5B shows a view from above of a detail of the testing head of Figure 5A, comparing known cantilever contact probes according to Figure 3A and cantilever contact probes according to the embodiment of the invention of Figure 4A,

- Figure 6 shows a perspective view of a cantilever contact probe according to an alternative embodiment of the invention,

- Figure 7 shows a perspective view of a testing head including cantilever contact probes according to Figure 6,

- Figures 7A and 7B show a front view of a detail of a testing head of Figure 7, comparing known cantilever contact probes of Figure 3A and cantilever contact probes according to the alternative embodiment of the invention of Figure 6, respectively,

- Figure 8 shows a perspective view of a cantilever contact probe according to a further alternative embodiment of the invention, and

- Figures 9A-9E show cross sections of cantilever contact probes according to alternative embodiments of the invention.

Detailed description

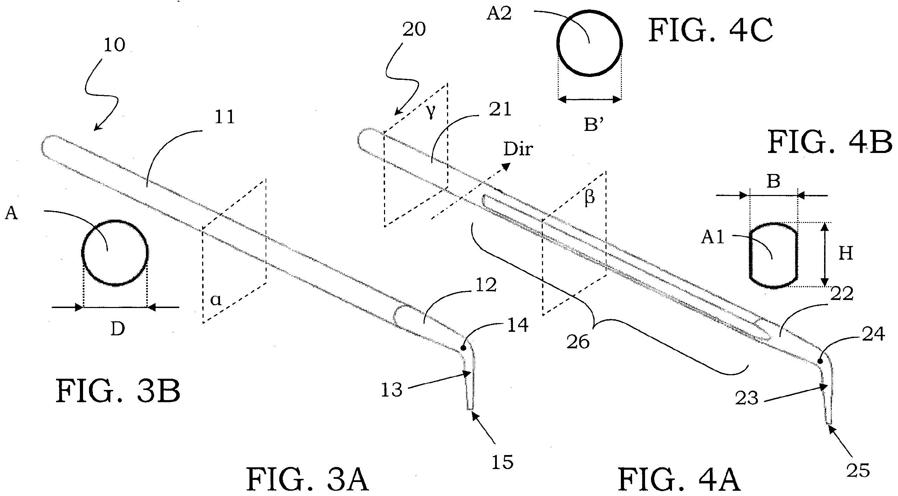

With particular reference to Figures 3A and 4A, a cantilever contact probe according to the prior art (Figure 3A) and a cantilever contact probe according to an embodiment of the invention (Figure 4A) are schematically shown.
In particular, the cantilever contact probe 10 according to the prior art, shown in Figure 3A, comprises a probe body 11 and an end portion 12, joined to the probe body 11 and ending with a slanted section 13, in a hook-shaped arrangement. As already said, the end portion 12 is bent at a bending point 14 with a suitable inclination of the slanted section 13 with respect to the axis of the probe body 11, and it ends with a contact tip 15, for contacting a plurality of contact pads 7 of a device under test.
The probe body 11 has a rod-like shape, having a substantially constant sectional area with a circular shape of diameter D, as schematically shown in Figure 3B, which shows a cross section of said probe body 11 at a transversal plane α as shown in Figure 3A.
Usually, for a probe having a total length between 3,8 and 8 cm, the length of the probe body 11 varies between 3,7 cm and 7,7 cm and the length of the hook-shaped end portion 12 varies between 1 mm and 3 mm, wherein the length of the slanted section 13 may vary between 0,15 mm and 1,5 mm. Furthermore, the diameter D of probe body 11 may vary between 50 $\mu$m and 300 $\mu$m, whereas the diameter d of contact tip 15, which is also substantially circular, may vary between 8 $\mu$m and 80 $\mu$m. In this way, the hook-shaped end portion 12 has a tapered frustoconical shape.
A cantilever contact probe according to the invention shown in Figure 4A, generally indicated in 20, comprises a probe body 21 and an end portion 22, joined to the probe body 21 and ending with a slanted hook-shaped section 23. The end portion 22 is bent at a bending point 24 with a suitable inclination of the slanted hook-shaped section 23, with respect to a longitudinal extension axis of the probe body 21, and ending with a contact tip 25, for contacting a plurality of contact pads 7 of a device under test.
Advantageously, according to the invention, the cantilever contact probe 20 comprises at least a reduced portion 26 having an area with at least a first size smaller than a corresponding first size of the area of the rest of the probe, in particular along the side by side placing direction of the probes inside a testing head, labeled as Dir in Figure 4A. More in particular, such reduced portion is reduced on the sides, forming an area of reduced cross size positioned edgeways, wherein such probes are positioned, as will be made clear in the following, in such a way as to protrude from a supporting ring on at least one level, intended to be the height of the point where the probes protrude from the supporting ring, or more precisely from the resin support associated to the same, with respect to a device under test, in a side by side arrangement of same probes. The probes on a given level may be considered as placed side by side along a plane, which we call probe plane, at a certain distance from a defined plane of the device under test, when the testing head comprising such probes is in contact and pressing on the same, wherein each level corresponds to a different distance between the probe plane and the plane of the device under test.

In the embodiment of Figure 4A, the cantilever contact probe 20 has a reduced portion 26, which is in particular provided in a section of the probe body 21 adjoining the end portion 22, having a first area A1 shown in Figure 4B, taken in correspondence of a first transversal plane β of Figure 4A with a first size B, in particular, a maximum size in the side by side direction of the probes Dir, and a second size H, in particular, a maximum size in a direction perpendicular to the side by side direction of the probes Dir. In essence, the first size B is the thickness of the reduced portion 26 of the cantilever contact probe 20 and the second size H is its height. In a preferred embodiment, the second size H is greater than the first size B.

The cantilever contact probe 20 also has a second area A2 shown in Figure 4C, taken in correspondence of a second transversal plane γ in Figure 4A, therefore corresponding to the probe body 21, where the reduced portion 26 is absent, the area A2 being circular with a diameter B', which in the example shown is equal to the area A of the cantilever contact probe 10 of Figure 3A.

The reduced portion 26 may be provided by suitable working of the cantilever contact probe 20, for example by removing material in a symmetrical fashion with respect to the longitudinal extension axis of the cantilever contact probe 20, from a section of the probe body 21, providing a sort of symmetrical recess in that section.

Advantageously, according to the invention, the first size B of the first area A1, taken in correspondence of the reduced portion 26, is smaller than the first size B' of the second area A2, taken in correspondence of the section of the probe body 21 lacking the reduced portion 26, along the same side by side direction of the probes Dir, and transversally with respect to the probe body 21. In a preferred embodiment, the second area A2 has a circular shape with a diameter B', and the second size H of the first area A1 is equal to said diameter B'.

In a further preferred embodiment, the first size B of the first area A1 of the reduced portion 26 is equal to even 20% of the first size B' of the second area A2 along the same side by side placing direction of the probes Dir. In general, the ratio between the first size B of the first area A1 and the first size B' of the second area is chosen between 0.30 and 0.95.

The hook-shaped end portion 22 of each cantilever contact probe 20 ends with a contact tip 25, wherein such tip is such as to abut against and contact a plurality of contact pads of a device under test.

It has to be noted that the provision of the reduced portion 26 in the probe body 21 alters the elastic properties of the cantilever contact probe 20 as a whole, and in particular of the probe body 21, and allows a reduction of the number of levels at which the probes have to be positioned.

For a probe with a total length varying between 3.8 cm and 8 cm, the length of the probe body 21 varies between 3.7 cm and 7.7 cm, and the length of the hook-shaped end portion 22 varies between 1 mm and 3 mm and the length of the slanted section 23 may vary between 0.15 mm and 1.5 mm. Furthermore, the first size B' or diameter of the probe body 21 in circular probes may vary between 50 $\mu$m and 300 $\mu$m, whereas the diameter d of the contact tip 25, which is also essentially circular in shape, may vary between 8 $\mu$m and 80 $\mu$m.

In an exemplary embodiment, the value of the first size B of the reduced portion 26 varies between 25 $\mu$m and 200 $\mu$m and the value of the second size H of the reduced portion 26 varies between 50 $\mu$m and 400 $\mu$m, whereas the first size B' of the section of the probe body 21 not comprising the reduced portion 26 may vary between 50 $\mu$m and 300 $\mu$m.

Advantageously, according to the invention, the contact tip 25 may also have a contact portion, which is suitably corrugated, in order to abut against a covering layer or film (oxide or dirt in general) overlaying the contact pad of the device under test.

Advantageously, in this way, according to the invention, the contact tip 25 "sticks" at the impact area on the contact pad, limiting the scrubbing action by the same tip, wherein the probe 20 presses in contact against the contact pad, which has traveled vertically, by a distance called overtravel OT.

The hook-shaped end portion 22 of the cantilever contact probe 20 according to the invention therefore deforms during such pressing contact against the contact pad, wherein its horizontal movement or scrub against the same pad is limited by the corrugated contact portion being stuck on the covering layer of the contact pads.

It is also to be noted that such sticking action is eased by the reduced portion 26 provided in the probe body 21, which improves the flexibility of the probe. By using cantilever contact probes 20 according to the invention, scrub marks are therefore reduced with respect to the probes according to the prior art.

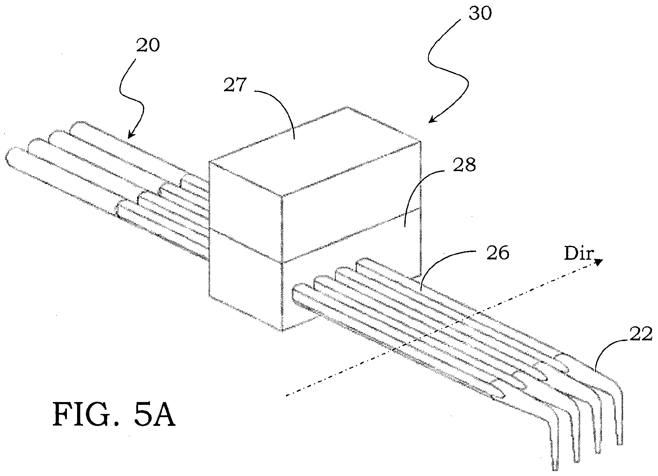

A testing head according to an embodiment of the invention is schematically and partially shown in Figure 5A, globally labeled as 30. In particular, the testing head 30 comprises a ring support 27 made of aluminum, ceramics or other suitable material to which a further resin support 28 is jointly coupled, able to include a plurality of cantilever contact probes 20, in order for the same to be essentially aligned on a same level, considered as the level or height at which the cantilever contact probes 20 exit from the further resin support 28 with respect to a ideal plane formed by the device under test, when the testing head 30 is pressing in contact against the same.

In the embodiment shown in Figure 5A, the cantilever contact probes 20 are included in the further resin support 28 at their corresponding reduced portions 26, which are provided, as in the example shown in Figure 4A, on the probe body 21.

It is therefore clear that in the testing head 30, the cantilever contact probes 20 may be more narrowly spaced in the further resin support 28, with respect to cantilever contact probes 10 made according to prior art, due to the reduced size precisely in the side by side direction of the probes Dir, in particular the first size B of the first area A1 at the reduced portion 26.

A testing head 30 can therefore be provided which is able to test devices having a reduced pitch with respect to those that may be tested by a traditional testing head of the prior art.

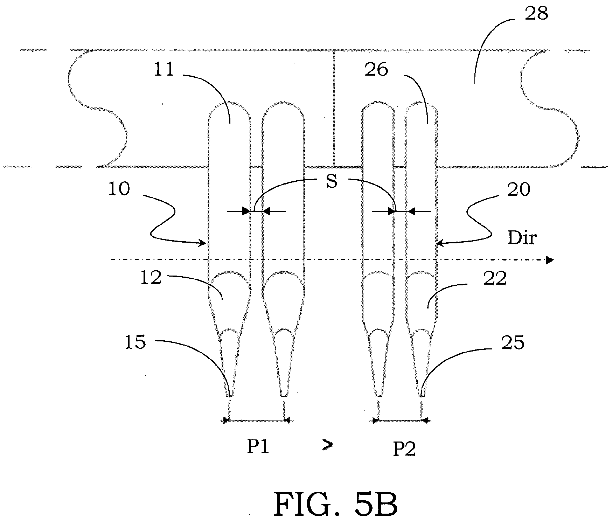

In order to completely appreciate the advantageous characteristics of the testing head 30 comprising cantilever contact probes 20 according to the invention, one may refer to Figure 5B, where, in the left portion, a pair of cantilever contact probes 10 made according to the prior art is shown, which are placed side by side and contiguous to each other along the direction Dir, having a substantially circular cross section, whereas the portion on the right shows a pair of cantilever contact probes 20 made according to the invention, which are similarly placed side by side and contiguous to each other, at their reduced portions 26.

It is readily understood that distance P1 between the contact tips 15 of cantilever contact probes 10 according to prior art is greater than distance P2 between the contact tips 25 of the cantilever contact probes 20 according to the invention, having both the same safety distance S between probes. In this way, the cantilever contact probes 20 are able to contact pads, whose distance between centers, or pitch, is less than the pitch of the cantilever contact probes 10 of the known type (P2 < P1).

It is also possible to ascertain that the testing head 30 according to the invention allows the testing of devices having contact pads of extremely reduced size.

In fact, it is to be noted that the reduction of the first size B of the first area A1 of the reduced portion 26 of the probe body 21 allows an improvement of the elastic behavior of the cantilever contact probe 20 according to the invention, with reference to its deformation during testing, i.e. during the pressing contact of the contact tip 25 of the cantilever contact probe 20 against a contact pad of the device under test.

Advantageously, according to the invention, due to its corrugated contact portion, the contact tip 25 of the cantilever contact probe 20 in any case removes the covering film from the contact pad, on which it is stuck, ensuring a proper electrical contact of the probe 20 and hence a proper functioning of the testing head 30 comprising the same. The provision of the corrugated portion of the contact tip 25 also allows a reduction of the sliding movement of the contact tip 25 over the contact pad and therefore, as already said, the length of the scrub marks.

Summarizing, it is evident that, in the case of probe bodies 21 having the same size, the testing head according to the invention allows testing of devices having reduced pitch and small pads, ensuring high quality and reliability. New requirements imposed by new technologies, with reference to the more and more reduced sizes of the contact pads and pitch, are therefore met.

Since, due to the reduction of the scrub marks, the size of contact pads may be reduced, the testing head 30 also allows a great area saving for each device, and a greater number of devices fits on the same silicon area.

Finally, due to the configuration of the cantilever contact probes 20, a testing head 30 may be provided which has a lower number of levels with respect to those used in the prior art for testing the same device, wherein each level of cantilever contact probes 20 may contact a higher number of contact pads, thanks to the reduced distance between the respective contact tips 25.

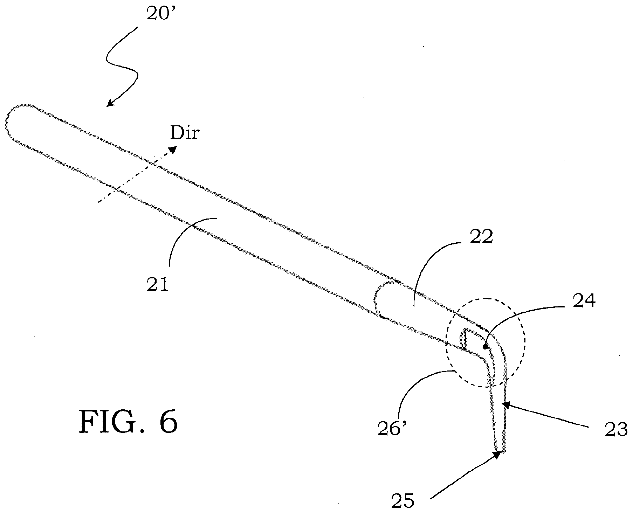

According to an alternative embodiment, a cantilever contact probe 20' comprises a reduced portion 26' at its end portion 22, as schematically shown in Figure 6. In particular, the reduced portion 26' is provided at the bending point 24 of the end portion 22, in a substantially symmetrical arrangement with respect to such bending point 24.

As previously shown, the reduced portion 26' may be manufactured by suitable working of the cantilever contact probe 20, for example by means of symmetrical material removal with respect to the longitudinal extension axis of the cantilever contact probe 20', from a section of the end portion 22, for example a section symmetrically positioned on the bending point 24, in order to provide a sort of symmetrical recess in said section.

Similarly to the embodiment of Figure 5A, the reduced portion 26' has a first area being similar to the area A1 as shown in Figure 4B, taken in correspondence of the bending point 24 with a first size B, in particular, a maximum size in the side by side direction of the probes Dir, and a second size H, in particular, a maximum size in a direction perpendicular to the side by side direction of the probes Dir.

The cantilever contact probe 20' also has a second area A2 as the one shown in Figure 4C, taken in correspondence of a end portion 22, where the reduced portion 26' is absent, having a first size B' in the side by side direction of the probes Dir being greater that the first size A1 taken in correspondence of the reduced portion 26'; in particular, the area A2 may have a circular shape with a diameter equal to the first size B'.

Advantageously, according to the invention, the first size B of the first area A1, taken in correspondence of the reduced portion 26, is smaller than the first size B' of the second area A2, taken in correspondence of the section of the probe body 21 lacking the reduced portion 26, along the same side by side direction of the probes Dir, and transversally with respect to the probe body 21. In a preferred embodiment, the second area A2 has a circular shape with a diameter B', and the second size H of the first area A1 is equal to said diameter B'.

Similarly to the preceding embodiment, the first size B of the first area A1 of the reduced portion 26' is up to 20% of the first size B' of the second area A2 along the same side by side direction of the probes Dir. In general, the ratio between the first size B and second size H is chosen between 0.30 and 0.95.

The hook-shaped end portion 22 of each cantilever contact probe 20, in particular its slanted section 23, ends with a contact tip 25, whose diameter is essentially equal to the known probes' one, wherein said tip is such as to abut and contact against a plurality of contact pads of the device under test.

Also according to this second embodiment, the provision of the reduced portion 26' in the end portion 22 improves the elastic properties of such end portion 22 and of the cantilever contact probe 20 as a whole, also allowing a reduction of the length of the slanted sections 23.

In the probe according to this alternative embodiment, in particular with reference to its length and the length of its individual portions, dimensional values equal to those of the probe as previously described and shown in Figure 4A are presumed.

In an exemplary embodiment, the value of the first size B of the reduced portion 26' varies between 20 $\mu$m and 180 $\mu$m and the value of the second size H of the reduced portion 26' varies between 50 $\mu$m and 400 $\mu$m, whereas the first size B' of the section of the end portion 22 not comprising the reduced portion 26' may vary between 30 $\mu$m and 200 $\mu$m.

The contact tip 25 may also comprise a contact portion suitably corrugated, such as to abut against a covering layer or film (oxide or dirt in general), overlaying the contact pad of the device under test, so that the contact tip 25 is able to "stick" at the impact zone on the contact pad, limiting the scrub and, as previously indicated, forming smaller scrub marks.

In this case, too, the sticking action is facilitated by the provision of the reduced portion 26' in the hook-shaped end portion 22, with an improved elastic behavior during testing.

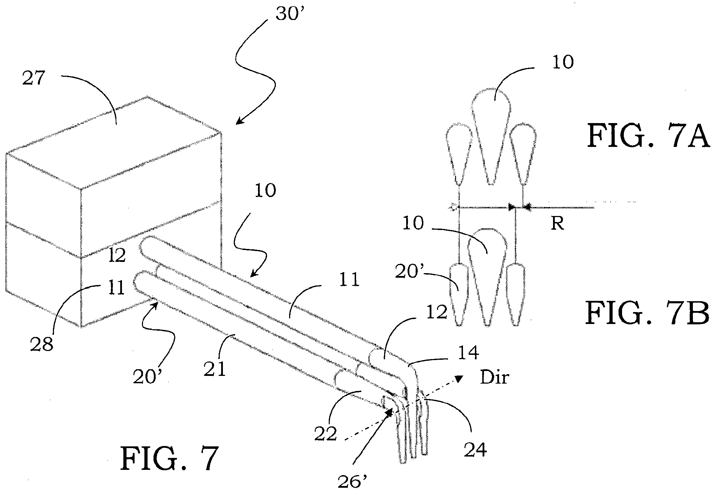

Such alternative embodiment is particularly advantageous in case of positioning the cantilever contact probes on multiple levels, as schematically shown in Figures 7, 7A and 7B.

In particular, Figure 7 schematically shows a testing head 30' comprising cantilever contact probes on at least two levels, 11 and 12.

As previously shown, the testing head 30' comprises a ring support 27, made of aluminum, ceramics or other suitable material, to which a further resin support 28 is solidly joined, such as to include a first plurality of cantilever contact probes 20 aligned on a first level 11, as well as a second plurality of cantilever contact probes aligned on a second level 12, in particular a higher level, i.e. at a greater distance from the device under test.

It is pointed out that, advantageously, according to the invention, the cantilever contact probes at the second level 12 may be provided using cantilever contact probes without reduced portions, as those indicated by 10 in Figure 3A. In particular, the end portions 12 of the cantilever contact probes 10 at the second level are such as to be housed without risking any contacting between the end portions 22 of the cantilever contact probes 20' of the first level 11, due to provision of the reduced portions 26' being realized at corresponding bending points 24 of the cantilever contact probes 20' of the first level, indeed, with a substantial reduction of the distances between respective contact tips 25.

More in particular, based on comparison of Figures 7A and 7B, it is possible to confirm that the two level configuration of the testing head 30' comprising a first level 11 of cantilever contact probes 20' according to embodiment in Figure 6 and a second level 12 of cantilever contact probes 10 of the known type (shown in Figure 7B), is able to position the respective contact tips 25 closer with respect to the testing head only comprising known cantilever contact probes 10 (shown in Figure 7A), with a reduction of total distance between the contact tips of the probes at the first level 11 equal to R.

It is therefore evident that also the testing head 30' comprising at least one level 11 of cantilever contact probes 20' according to the embodiment of Figure 6 is such as to allow the testing of devices with smaller pitch with respect to a traditional testing head only comprising cantilever contact probes 10 of Figure 3A.

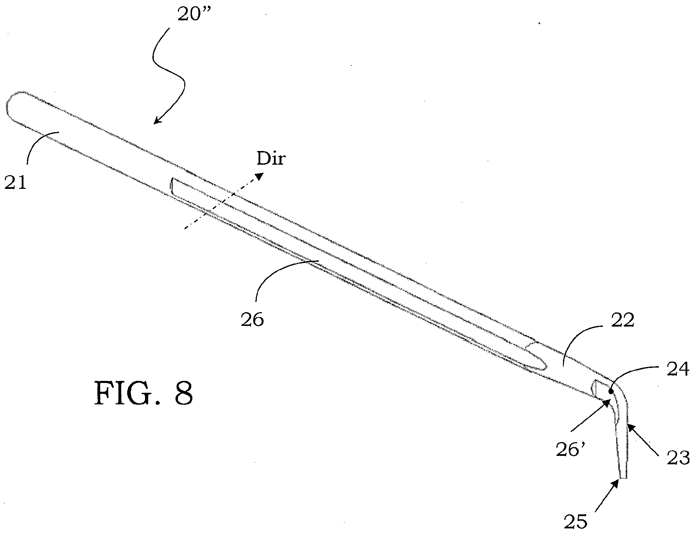

Advantageously, according to a further alternative embodiment schematically shown in Figure 8, a cantilever contact probe 20" may comprise a first reduced portion 26 in a section of the probe body 21 which is contiguous to the end portion 22 and a second reduced portion 26' at an end portion 22, in particular, at a bending point 24 of the end portion 22, in a substantially symmetrical arrangement with respect to the bending point 24.

In the probe according to this further embodiment, in particular, with reference to its length and the length of the individual portions and the sizes of different areas are presumed to have dimensional values equal to those of the probes, previously described and shown in Figures 4A and 6.

A testing head comprising cantilever contact probes 20" according to further embodiment of Figure 8 clearly allow a further reduction of the distance of the respective contact tips 25, for testing devices having extremely small pitches.

In this case too, the contact tip 25 of the cantilever contact probes 20" may have a suitably corrugated contact portion able to abut against a covering layer or film (oxide or dirt in general) overlaying the contact pad of the device under test, such as to allow testing of devices having contact pads of extremely small size.

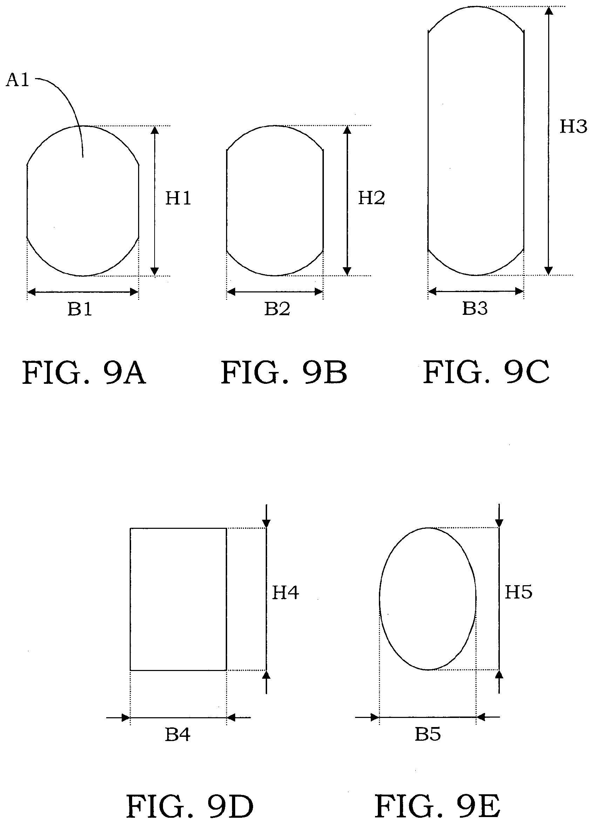

Possible areas of the reduced section of the contact probes according to the present invention are shown, as non limiting examples, in Figures 9A to 9F.

As is shown in these figures, the areas of the reduced portions of the cantilever contact probes according to the present invention may be substantially rectangular, with variable base and height, or even substantially elliptical, with variable major and minor axes.

The choice of the sections of the reduced portions may be based on different criteria:

- starting with a defined pitch, required by the device under test, it is possible to establish a value of the first size B, sufficient to ensure a lack of contact between adjacent and contiguous probes;

- based on the current capacity required by a defined test, it is possible to establish a value of the second size H, also based on the value already determined for the first size B.

In particular, as shown in Figure 9A, a cantilever contact probe, for example a probe 20 as shown in Figure 4A, may have a first size B1 of its first area A1 at its reduced portion 26, sufficient to contact a device having a first pitch P1.

In case of testing a device having a second pitch P2 smaller than the first pitch P1, it is possible to use a cantilever contact probe 20 with a reduced portion 26 with a first further reduced size B2 of its area A1, as shown in Figure 9B, being B1 > B2 and H1 = H2.

Furthermore, if the value of the first size B3 of the section of the cantilever contact probe 20 at its reduced portion 26 is sufficient to ensure the proper pitch required by the device under test, it may be necessary to perform a test with a higher current requirement. In this case, a cantilever contact probe 20 having a higher current capacity may be provided, increasing the second size H3, as shown in Figure 9C, being B3 = B2 and H3 > H2.

The areas shown in Figures 9A-9C have two opposed rectilinear sides and two opposed curvilinear sides. It is also possible to use cantilever contact probes 20 having reduced portions 26 with a rectangular cross section, as shown in Figure 9D or elliptical cross section, as shown in Figure 9E, being B4 = B5 and H4 = H5. Moreover, the reduced portion 26 may also have a square section, with a side shorter than the diameter of the probe body portion 21, respectively of the end portion 22, not comprising the reduced portion 26, respectively 26'.

Similar considerations may also be made for the probes 20' and 20" of Figures 6 and 8, respectively, and for the respective reduced portions 26, 26'.

Other and different embodiments of the reduced portions 26 of the cantilever contact probe 20 may also be taken into account.

It is also noted that the value of the sizes B and H of the reduced portion 26 of the cantilever contact probes 20 may also be modified for controlling the contact force or for increasing their balancing in case probes with hooks of different length have to be used, or if it is necessary to contact pads inside the device, as is the case of last generations of integrated devices comprising contact pads which are provided also inside the device, in addition to its periphery.

Summarizing, the testing head comprising cantilever contact probes according to the different embodiments as shown allows:

- a reduction of the number of levels at which the probes are positioned, with a corresponding balancing of forces and improved uniformity of the scrub action over the contact pads;

- an increase of the length of the hooks of the contact probes positioned on a reduced number of levels, therefore increasing the working life of the testing head, which is tied to the wear of the hooks, indeed;

- an increase of probe's diameter, without the risk of mutual collision between the same, therefore improving the current capacity of the probes;

- a reduction of the length of the scrub marks, at a same overtravel;

- a reduction of the usable pitch value;

- a reduction of the size of the contactable contact pads;

- an increase of the distance between the probes, therefore obtaining an easier and more reliable manufacturing of the testing head as a whole.

More in particular, the provision of the reduced portion 26 allows different and important advantages, among which are the following:

- improving the balance of forces, which may be regulated by varying the first size of the reduced portion 26, 26', in particular, the depth of the groove on the probe body 21, as a function of the length of the slanted hook-shaped section 23, which characterizes various levels of probes;

- improving the balance of forces, when the device under test has various internal pads,

- improving the uniformity of the scrubs obtained on the pads by controlling the respective scrub's length up to almost eliminating the same (when the scrub mark is slightly larger than the size of the contact tip of the probe, the removal of the dirt layer on the pad and therefore a proper electrical connection being obtained due to sticking of the contact tip on the same pad).

- possible increase of the current capacity of the probe, due to a suitable increase of the second size H of the probe body 21 in a transversal direction with respect to the side by side placing direction of the probes Dir.

**Claims**

1. Cantilever contact probe (20, 20', 20") comprising at least a probe body (21) and a hook-shaped end portion (22), being joined to said probe body (21) and ending with a slanted section (23) being configured as a hook, said end portion (22) being bent at a bending point (24) having a suitable inclination of said hooked slanted section (23) with respect to a longitudinal extension axis of said probe (20, 20', 20") and ending with a contact tip (25) being able to assure a mechanical and electrical contact with a contact pad of a device under test, **characterized in that it comprises** at least a reduced portion (26, 26') having a first area (A1) with at least a first size (B) being smaller than a corresponding first size (B') of a second area (A2) of said probe in a section which does not comprise said reduced portion (26, 26'), along a side by side placing direction of the probes (Dir) within a testing head, said reduced portion (26, 26') being substantially reduced along its sides thus forming an area having a reduced cross size being placed edgeways, said first area (A1) having a second size (H) along the orthogonal direction with respect to said side by side placing direction of the probes (Dir) being equal to a size of said second area (A2) along a same orthogonal direction, equal to said first size (B').

2. Cantilever contact probe (20, 20', 20") according to claim 1, **characterized in that** the ratio between said first size (B) of said first area (A1) at said reduced portion (26, 26') and said first size (B') of said second area (A2) is chosen in the range 0.30-0.95.

3. Cantilever contact probe (20, 20', 20") according to any of the preceding claims, **characterized in that** said reduced portion (26) is symmetrical with respect to said longitudinal extension axis of said probe (20, 20', 20").

4. Cantilever contact probe (20, 20', 20") according to any of the preceding claims, **characterized in that** said contact tip (25) comprises a corrugated contact portion.

5. Cantilever contact probe (20, 20") according to any of the preceding claims, **characterized in that** said reduced portion (26) is made in a section of said probe body (21) adjoining said end portion (22).

6. Cantilever contact probe (20') according to any of claims 1-4, **characterized in that** said reduced portion (26') is made in a section of said end portion (22) at said bending point (24).

7. Cantilever contact probe (20") according to claim 5, **characterized in that** it comprises said reduced portion (26) being made in a section of said probe body (21) adjoining said end portion (22) and a further reduced portion (26') being made in a section of said end portion (22) at said bending point (24).

8. Cantilever contact probe (20, 20', 20") according to any of the preceding claims, **characterized in that** the value of said first size (B) of said first area (A1) at said reduced portion (26, 26') is chosen according to a value of a distance between the centers of the contact pads of said device under test.

9. Cantilever contact probe (20, 20', 20") according to any of the preceding claims, **characterized in that** the value of said second size (H) of said first area (A1) at said reduced portion (26, 26') is chosen according to a value of a current that the probe should sustain.

10. Cantilever contact probe (20, 20', 20") according to any of the preceding claims, **characterized in that** the values of said first and second sizes (B, H) of said first area (A1) at said reduced portion (26, 26') are chosen to control the contact force of said probe (20, 20', 20") onto a contact pad of said device under test or to balance probes having slanted sections (23) of different length or to contact pads being internal to said device.

11. Cantilever contact probe (20, 20', 20") according to any of the preceding claims, **characterized in that** said first area (A1) in correspondence with said reduced portion (26, 26') has a shape being chosen between a substantially quadrilateral figure which comprises two opposed rectilinear sides and two opposed curvilinear sides, a rectangle, a square, an ellipse.

12. Testing head (30) comprising at least a ring support (27) which is jointly coupled to a further resin support (28) being able to include a plurality of cantilever contact probes (20, 20', 20") being realized according to any of the preceding claims.

13. Testing head (30) according to claim 12, **characterized in that** it comprises at least a first level (11) of contact probes (20', 20") having at least a reduced portion (26') which is realized in a section of said end portion (22) at said bending point (24) and a second level (12) of contact probes being devoid of said reduced portion.

**Patentansprüche**

1. Cantilever- bzw. Tragarm-Kontaktsonde (20, 20', 20"), umfassend mindestens einen Sondenkörper (21) und einen hakenförmigen Endabschnitt (22), der mit dem Sondenkörper (21) verbunden ist und der mit einem geneigten Abschnitt (23) endet, welcher als ein Haken konfiguriert ist, wobei der Endabschnitt (22), der an einem Biegepunkt (24) gebogen ist, eine geeignete Neigung des hakenförmigen geneigten Abschnitts (23) in Bezug auf eine Achse der Längsausdehnung der Sonde (20, 20', 20") aufweist und mit einer Kontaktspitze (25) endet, die in der Lage ist, einen mechanischen und elektrischen Kontakt mit einem Kontaktfeld einer zu prüfenden Vorrichtung zu gewährleisten, **dadurch gekennzeichnet, dass** sie zumindest einen reduzierten Abschnitt (26, 26'), der einen ersten Bereich (A1) mit zumindest einer ersten Abmessung (B) umfasst, die kleiner ist als eine entsprechende erste Abmessung (B') eines zweiten Bereichs (A2) der Sonde in einem Abschnitt, der nicht den reduzierten Abschnitt (26, 26') aufweist, entlang einer Seite an Seite anordnenden Richtung der Sonden (Dir) innerhalb eines Prüfkopfes umfasst, wobei der reduzierte Abschnitt (26, 26') im wesentlichen entlang seiner Seiten reduziert ist und damit einen Bereich mit reduzierter Querschnittsabmessung aufweist, die kantengestellt angeordnet ist, wobei der erste Bereich (A1) eine zweite Abmessung (H) entlang der orthogonalen Richtung in Bezug auf die Seite an Seite anordnende Richtung der Sonden (Dir) hat, die von der gleichen Abmessung ist wie der zweite Bereich (A2) entlang einer gleichen orthogonalen Richtung, gleich der ersten Abmessung (B').

2. Kontaktsonde (20, 20', 20") nach Anspruch 1, **dadurch gekennzeichnet, dass** das Verhältnis zwischen der ersten Abmessung (B) des ersten Bereichs (A1) am reduzierten Abschnitt (26, 26') und der ersten Abmessung (B') des zweiten Bereichs (A2) im Bereich von 0,30 bis 0,95 gewählt ist.

3. Kontaktsonde (20, 20', 20") nach einem der vorhergehenden Ansprüche, **dadurch gekennzeichnet, dass** der reduzierte Abschnitt (26) symmetrisch ist in Bezug auf die Achse der Längsausdehnung der Sonde (20, 20', 20").

4. Kontaktsonde (20, 20', 20") nach einem der vorhergehenden Ansprüche, **dadurch gekennzeichnet, dass** die Kontaktspitze (25) einen gewellten Kontaktbereich aufweist.

5. Kontaktsonde (20, 20") nach einem der vorhergehenden Ansprüche, **dadurch gekennzeichnet, dass** der reduzierte Abschnitt (26) in einem Bereich des Sondenkörpers (21) ausgebildet ist, der an den Endabschnitt (22) anschließt.

6. Kontaktsonde (20') nach einem der Ansprüche 1-4, **dadurch gekennzeichnet, dass** der reduzierte Abschnitt (26') in einem Bereich des Endabschnitts (22) an dem Biegepunkt (24) ausgebildet ist.

7. Kontaktsonde (20") nach Anspruch 5, **dadurch gekennzeichnet, dass** sie einen reduzierten Abschnitt (26), der in einem Bereich des Sondenkörpers (21) ausgebildet ist, der an den Endabschnitt (22) anschließt und einen weiteren reduzierten Abschnitt (26') umfasst, der in einem Bereich des Endabschnitts (22) an dem Biegepunkt (24) ausgebildet ist.

8. Kontaktsonde (20, 20', 20") nach einem der vorhergehenden Ansprüche, **dadurch gekennzeichnet, dass** der Wert der ersten Abmessung (B) des ersten Bereichs (A1) an dem reduzierten Abschnitt (26, 26') entsprechend einem Wert eines Abstandes zwischen den Mittelpunkten der Kontaktfelder der zu prüfenden Vorrichtung ausgewählt ist.

9. Kontaktsonde (20, 20', 20") nach einem der vorhergehenden Ansprüche, **dadurch gekennzeichnet, dass** der Wert der zweiten Abmessung (H) des ersten Bereichs (A1) an dem reduzierten Abschnitt (26, 26') entsprechend einem Wert eines Stroms ausgewählt ist, den die Sonde aushalten sollte.

10. Kontaktsonde (20, 20', 20") nach einem der vorhergehenden Ansprüche, **dadurch gekennzeichnet, dass** die Werte der ersten und der zweiten Abmessungen (B, H) des ersten Bereichs (A1) an dem reduzierten Abschnitt (26, 26') ausgewählt sind, um die Kontaktkraft der Kontaktsonde (20, 20', 20") auf das Kontaktfeld der zu prüfenden Vorrichtung zu kontrollieren oder Sonden, die abgeschrägte Abschnitte (23) mit unterschiedlicher Länge haben, auszubalancieren oder Kontaktfelder, die intern in der Vorrichtung sind, zu kontaktieren

11. Kontaktsonde (20, 20', 20") nach einem der vorhergehenden Ansprüche, **dadurch gekennzeichnet, dass** der erste Bereich (A1) in Übereinstimmung mit dem reduzierten Abschnitt (26, 26') eine Form hat, die ausgewählt ist aus einer im Wesentlichen vierseitigen Figur, die zwei gegenüberliegende geradlinige Seiten und zwei gegenüberliegende gekrümmte Seiten hat, einem Rechteck, einem Quadrat und einer Ellipse.

12. Prüfkopf (30), der zumindest einen Ringträger (27) hat, der gemeinsam gekoppelt ist mit einem weiteren Kunststoffträger (28), der eine Vielzahl von Cantilever-Kontaktsonden (20, 20', 20") aufnehmen kann, die nach einem der vorhergehenden Ansprüche realisiert sind.

13. Prüfkopf (30) nach Anspruch 12, **dadurch gekennzeichnet, dass** er mindestens ein erstes Niveau (I1) von Kontaktsonden (20', 20"), die wenigstens einen reduzierten Abschnitt (26') aufweisen, welcher in einem Bereich des Endabschnitts (22) an dem Biegepunkt (24) realisiert ist und ein zweites Niveau (I2) von Kontaktsonden aufweist, die keinen reduzierten Bereich haben.

## Revendications

1. Sonde de contact cantilever (20, 20', 20") comprenant au moins un corps de sonde (21) et une partie d'extrémité en forme de crochet (22), qui est assemblée audit corps de sonde (21) et se terminant par une section inclinée (23) qui est configurée comme un crochet, ladite partie d'extrémité (22) étant pliée au niveau d'un point de pliage (24) ayant une inclinaison appropriée de ladite section inclinée en forme de crochet (23) par rapport à un axe d'extension longitudinal de ladite sonde (20, 20', 20") et se terminant par une pointe de contact (25) pouvant garantir le contact mécanique et électrique avec un plot de connexion d'un dispositif en phase de test, **caractérisée en ce qu'**elle comprend au moins une partie réduite (26, 26') ayant une première zone (A1) avec au moins une première taille (B) qui est inférieure à une première taille correspondante (B') d'une seconde zone (A2) de ladite sonde dans une section qui ne comprend pas ladite partie réduite (26, 26'), le long d'une direction de mise en place côte à côte des sondes (Dir) à l'intérieur d'une tête de test, ladite partie réduite (26, 26') étant sensiblement réduite le long de ses côtés, formant ainsi une zone ayant une taille transversale réduite qui est placée de côté, ladite première zone (A1) ayant une seconde taille (H) le long de la direction orthogonale par rapport à ladite direction de mise en place côte à côte des sondes (Dir) qui est égale à une taille de ladite seconde zone (A2) le long d'une même direction orthogonale, égale à ladite première taille (B').

2. Sonde de contact cantilever (20, 20', 20") selon la revendication 1, **caractérisée en ce que** le rapport entre la première taille (B) de ladite première zone (A1) au niveau de ladite partie réduite (26, 26') et ladite première taille (B') de ladite seconde zone (A2) est choisi dans la plage de 0,30-0,95.

3. Sonde de contact cantilever (20, 20', 20") selon l'une quelconque des revendications précédentes, **caractérisée en ce que** ladite partie réduite (26) est symétrique par rapport audit axe d'extension longitudinal de ladite sonde (20, 20', 20").

4. Sonde de contact cantilever (20, 20', 20") selon l'une quelconque des revendications précédentes, **caractérisée en ce que** ladite pointe de contact (25) comprend une partie de contact ondulée.

5. Sonde de contact cantilever (20, 20") selon l'une quelconque des revendications précédentes, **caractérisée en ce que** ladite partie réduite (26) est réalisée dans une section dudit corps de sonde (21) attenante à ladite partie d'extrémité (22).

6. Sonde de contact cantilever (20') selon l'une quelconque des revendications 1 à 4, **caractérisée en ce que** ladite partie réduite (26') est réalisée dans une section de ladite partie d'extrémité (22) au niveau dudit point de pliage (24).

7. Sonde de contact cantilever (20") selon la revendication 5, **caractérisée en ce qu'**elle comprend ladite partie réduite (26) qui est réalisée dans une section dudit corps de sonde (21) attenante à ladite partie d'extrémité (22) et une autre partie réduite (26') qui est réalisée dans une section de ladite partie d'extrémité (22) au niveau dudit point de pliage (24).

8. Sonde de contact cantilever (20, 20', 20") selon l'une quelconque des revendications précédentes, **caractérisée en ce que** la valeur de ladite première taille (B) de ladite première zone (A1) au niveau de ladite partie réduite (26, 26') est choisie selon une valeur d'une distance entre les centres des plots de connexion dudit dispositif en phase de test.

9. Sonde de contact cantilever (20, 20', 20") selon l'une quelconque des revendications précédentes, **caractérisée en ce que** la valeur de ladite seconde taille (H) de ladite première zone (A1) au niveau de ladite partie réduite (26, 26') est choisie selon une valeur d'un courant que la sonde doit supporter.

10. Sonde de contact cantilever (20, 20', 20") selon l'une quelconque des revendications précédentes, **caractérisée en ce que** les valeurs desdites première et seconde tailles (B, H) de ladite première zone (A1) au niveau de ladite partie réduite (26, 26') sont choisies pour contrôler la force de contact de ladite sonde (20, 20', 20") sur un plot de connexion dudit dispositif en phase de test ou pour équilibrer des sondes ayant des sections inclinées (23) de différente longueur ou pour entrer en contact avec des plots qui sont à l'intérieur dudit dispositif.

11. Sonde de contact cantilever (20, 20', 20") selon l'une quelconque des revendications précédentes, **caractérisée en ce que** ladite première zone (A1) en correspondance avec ladite partie réduite (26, 26') a une forme qui est choisie entre une figure sensiblement quadrilatérale qui comprend deux côtés rectilignes opposés et deux côtés curvilignes opposés, un rectangle, un carré, une ellipse.

12. Tête de test (30) comprenant au moins un support d'anneau (27) qui est couplé conjointement à un autre support de résine (28) qui peut comprendre une pluralité de sondes de contact cantilever (20, 20', 20"), qui est réalisé selon l'une quelconque des revendications précédentes.

13. Tête de test (30) selon la revendication 12, **caractérisée en ce qu'**elle comprend au moins un premier niveau (I1) de sondes de contact (20', 20") ayant au moins une partie réduite (26') qui est réalisée dans une section de ladite partie d'extrémité (22) au niveau dudit point de pliage (24) et un second niveau (I2) de sondes de contact qui est dépourvu de ladite partie réduite.

FIG. 1A
PRIOR ART

FIG. 1B
PRIOR ART

FIG. 2A
PRIOR ART

FIG. 2B
PRIOR ART

FIG. 4C

FIG. 4B

FIG. 3B

FIG. 3A

FIG. 4A

EP 2 926 150 B1

FIG. 5A

EP 2 926 150 B1

FIG. 5B

EP 2 926 150 B1

EP 2 926 150 B1

20'

Dir

22

24

21

26'

23

25

FIG. 6

FIG. 7

FIG. 7A

FIG. 7B

EP 2 926 150 B1

FIG. 8

EP 2 926 150 B1

FIG. 9A    FIG. 9B    FIG. 9C

FIG. 9D    FIG. 9E

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20080204062 A